# EUROPEAN PATENT SPECIFICATION

(11) **EP 2 950 050 B1**
(45) Date of publication and mention of the grant of the patent: **31.05.2017**
(21) Application number: 15162618.1
(22) Date of filing: 07.04.2015
(51) Int. Cl.: G01D 4/00, G01D 1/08, G01R 21/133, G05B 15/02

(54) **METHOD, APPARATUS AND SYSTEM FOR COUNTING ELECTRICITY CONSUMPTION AND PROGRAM PRODUCT**
VERFAHREN, VORRICHTUNG UND SYSTEM ZUM ZÄHLEN DES STROMVERBRAUCHS UND PROGRAMMPRODUKT
PROCÉDÉ, APPAREIL ET SYSTÈME POUR LE COMPTAGE DE LA CONSOMMATION D'ÉLECTRICITÉ ET PRODUIT LOGICIEL

(30) Priority: 30.05.2014 CN 201410238910
(43) Date of publication of application: 02.12.2015
(73) Proprietor: Xiaomi Inc., Beijing 100085 (CN)
(72) Inventor: Liu, Guoming, BEIJING 100085 (CN)
(74) Representative: Delumeau, François Guy

(56) References cited:
- US-A1- 2012 016 608
- US-A1- 2013 110 621
- US-A1- 2013 132 008

## Description

### TECHNICAL FIELD

The present disclosure generally relates to the field of smart home, and more particularly to a method, an apparatus and a system for counting electricity consumption.

### BACKGROUND

In a smart home system, a control center is generally required to control and inquiry various devices connected thereto. Therefore, the control center and every connected device have to be always kept in power-up state. In the smart home system, it is extremely essential to carry out statistical analysis of electricity consumption respectively for all connected devices, so as to identify electricity consumption for each connected device at all times.

In the prior art, a switch with an electricity meter may be used to count electricity consumption of a device controlled by the switch. In the smart home system, a switch with an electricity meter may be used for every connected device to monitor the electricity consumption of every connected device. After that, a user may read readings of respective electricity meter, and then carry out statistical analysis of electricity consumption for every connected device.

However, in such a manner mentioned above, the number of the connected devices corresponds to the number of the switches with an electricity meter. That is, statistically, N switches with an electricity meter have to be installed for N connected devices, i.e. N electricity meters are required. Therefore, the number of the required electricity meters is relative great, which results in a certain waste. Moreover, the readings of every electricity meter have to be read manually before corresponding statistics are made, which needs the user's effort and causes troublesome operations. Document US 2012/0016608 A1 discloses a method and a system thereof for monitoring residential appliances.

### SUMMARY

To overcome these problems existing in the prior art, the present disclosure is provided with a method, an apparatus, and a system for counting electricity consumption.

According to a first aspect of the disclosed embodiments, it is provided a method for counting electricity consumption, which is applicable to count electricity consumption for a plurality of electronic devices by using a smart electricity meter, a plurality of smart switches being connected with the smart electricity meter, and each of the smart switches being respectively connected with one or more of the plurality of electronic devices. The method comprises steps of:
sampling readings of the smart electricity meter and statuses of the smart switches at a set sampling time interval to obtain a plurality of groups of electricity parameters, each of the plurality of groups of electricity parameters including a reading of the smart electricity meter and the statuses of the smart switches;
determining an average power of each smart switches according to a part or all of the plurality of groups of electricity parameters;
determining working hours of each smart switch during a set statistical time period; and
determining an electricity consumption of each smart switch during the statistical time period according to the working hours and the average powers of the respective smart switches.

Alternatively, the step of determining an average power of each smart switches according to a part or all of the plurality of groups of electricity parameters, comprises the steps of:
selecting at least two groups of first electricity parameters from the plurality of groups of electricity parameters, wherein the at least two groups of the first electricity parameters are sampled in succession, and the status of each smart switch in the first electricity parameters undergoes no change;
determining a first overall average power of smart switches, whose statuses in the first electricity parameters are "on", according to the readings of the smart electricity meter in the first electricity parameters;
selecting at least two groups of second electricity parameters from the plurality of groups of electricity parameters, wherein the at least two groups of second electricity parameters are sampled in succession, the status of each smart switch in the second electricity parameters undergoes no change, and there is at least one difference between the statuses of the smart switches in the second electricity parameters and those in the first electricity parameters;
determining a second overall average power of smart switches, whose statuses in the second electricity parameters are "on", according to the readings of the smart electricity meter in the second electricity parameters; and
determining average powers of smart switch, whose statuses in the second electricity parameters have changed from those in the first electricity parameters, according to the first overall average power and the second overall average power.

Alternatively, the step of sampling readings of the smart electricity meter and statuses of the smart switches at a set sampling time interval to obtain a plurality of groups of electricity parameters, comprises the steps of:
controlling the status of each smart switch to be kept unchanged within a first sampling time period, and sampling readings of the smart electricity meter at the set sampling time interval to obtain a first reading; and
controlling the status of each smart switch to be kept unchanged in a second sampling time period, and sampling readings of the smart electricity meter at the set sampling time interval to obtain a second reading, wherein there is at least one difference between the statuses of the smart switches within the second sampling time period and those within the first sampling time period.

Alternatively, the step of determining an average power of each smart switch according to a part or all of the plurality of groups of electricity parameters, comprises the steps of:
determining a first overall average power of smart switches in on-state according to the first reading and the first sampling time period;
determining a second overall average power of smart switches in on-state according to the second reading and the second sampling time period; and
determining an average power of a smart switch, whose status within the second sampling time period has changed from that within the first sampling time period, according to the first overall average power and the second overall average power.

Alternatively, the step of determining working hours of each smart switch in a set statistical time period, comprises the steps of:
detecting if there is a turning-on instruction for turning on respective smart switches;
when the turning-on instruction is detected, turning on a smart switch, and controlling a timer, corresponding to the smart switch turned on, to start timing, a timer being correspondingly provided to a smart switch;
detecting if there is a turning-off instruction, the turning-off instruction being used to turn off respective smart switches;
when the turning-off instruction is detected, turning off a smart switch, and controlling a timer, corresponding to the smart switch turned off, to stop timing; and
determining if it comes to the end of the statistical time period, and if it does, reading a reading of the timer, and determining the working hours of each smart switch according to the reading of the timer.

According to a second aspect of the disclosed embodiments, it is provided an apparatus for counting electricity consumption. The apparatus comprises:
a sampling module configured to sample readings of a smart electricity meter and statuses of smart switches, each of the smart switches being connected with one or more electronic devices, at a set sampling time interval to obtain a plurality of groups of electricity parameters, each of the plurality of groups of electricity parameters including a reading of the smart electricity meter and the statuses of the smart switches;
a power determination module configured to determine an average power of each smart switch according to a part or all of the plurality of groups of electricity parameters;
a time length determination module configured to determine working hours of each smart switch during a set statistical time period; and
an electricity consumption determination module configured to determine electricity consumption of each smart switch during the statistical time period according to the working hours and the average power of each smart switch.

Furthermore, the power determination module comprises:
a first selection unit configured to select at least two groups of first electricity parameters from the plurality of groups of electricity parameters, wherein the at least two groups of first electricity parameters are sampled in succession, and the status of each smart switch in the first electricity parameters undergoes no change;
a first determination unit configured to determine a first overall average power of smart switches in on-state among the first electricity parameters according to the readings of the smart electricity meter in the first electricity parameters;
a second selection unit, configured to select at least two groups of second electricity parameters from the plurality of groups of electricity parameters, wherein the at least two groups of second electricity parameters are sampled in succession, the status of each smart switch in the second electricity parameters undergoes no change, and there is at least one difference between the statuses of the smart switches in the second electricity parameters and those in the first electricity parameters;
a second determination unit configured to determine a second overall average power of smart switches in on-state among the second electricity parameters according to the readings of the smart electricity meter in the second electricity parameters; and

a third determination unit, configured to determine an average power of smart switch, whose status in the first electricity parameters has changed from that in the second electricity parameters, according to the first overall average power and the second overall average power.

Alternatively, the sampling module comprises:
a first control unit configured to control the status of each smart switch to be kept unchanged in a first sampling time period, and sample readings of the smart electricity meter at the set sampling time interval to obtain a first reading; and
a second control unit configured to control the status of each smart switch to be kept unchanged in a second sampling time period, and sample readings of the smart electricity meter at the set sampling time interval to obtain a second reading, wherein there is at least one difference between the statuses of the smart switches within the second sampling time period and those within the first sampling time period.

Furthermore, the first determination unit is further configured to determine a first overall average power of smart switches in on-state according to the first reading and the first sampling time period;
the second determination unit is further configured to determine a second overall average power of smart switches in on-state according to the second reading and the second sampling time period; and

the third determination unit is further configured to determine an average power of a smart switch, whose status within the second sampling time period has changed from that within the first sampling time period, according to the first overall average power and the second overall average power.

Alternatively, the time length determination module comprises:
a detection unit configured to detect if there is a turning-on instruction, which is used to turn on respective smart switches;
a turning-on unit configured to turn on a smart switch when the turning-on instruction is detected, and control a timer corresponding to the smart switch turned on, to start timing, a timer being correspondingly provided to a smart switch;
the detection unit further configured to detect if there is a turning-off instruction for turning off respective smart switches;
a turning-off unit configured to turn off a smart switch when the turning-off instruction is detected, and control a timer, corresponding to the smart switch turned off, to stop timing; and

a processing unit configured to determine if it comes to the end of the statistical time period, and if it does, read a reading of the timer, and determine the working hours of respective smart switches according to the reading of the timer.

According to a third aspect of the disclosed embodiments, it is provided an apparatus for counting electricity consumption. The apparatus comprises:
a processor;
a memory configured to store instructions executable by the processor;
wherein, the processor is configured to:
   sample readings of the smart electricity meter and statuses of the smart switches at a set sampling time interval to obtain a plurality of groups of electricity parameters, each of the plurality of groups the electricity parameters including a reading of the smart electricity meter and statuses of the smart switches;
   determine an average power of respective smart switches according to a part or all of the plurality of groups of electricity parameters;
   determine a working hours of the respective smart switches in a set statistical time period; and
   determine an electricity consumption of the respective smart switches in the statistical time period according to the working hours and the average power of the respective smart switches.

According to a fourth aspect of the disclosed embodiments, it is provided a system for counting electricity consumption. The system comprises:
a smart electricity meter, a plurality of smart switches and a terminal, wherein each of the smart switches is connected with one or more electronic devices, each of the smart switches being connected with the smart electricity meter, each of the smart switches and the smart electricity meter are wirelessly connected with the terminal, and the terminal is provided therein with an apparatus according to the second or third aspect of the disclosed embodiments.

A computer program is provided according to a fifth aspect of the present disclosure. The computer program performs the steps of the method for counting electricity consumption when this program is executed by a computer.

This program can use any programming language and take the form of source code, object code or a code intermediate between source code and object code, such as a partially compiled form, or any other desirable form.

The invention is also directed to a computer-readable information medium containing instructions of a computer program as described above.

The information medium can be any entity or device capable of storing the program. For example, the support can include storage means such as a ROM, for example a CD ROM or a microelectronic circuit ROM, or magnetic storage means, for example a diskette (floppy disk) or a hard disk.

Alternatively, the information medium can be an integrated circuit in which the program is incorporated, the circuit being adapted to execute the method in question or to be used in its execution.

Technical solutions provided by the embodiments of the present disclosure may achieve the following advantageous effects.

By sampling a plurality of groups of electricity parameters at the set sampling time interval, determining the average power of each smart switch according to the electricity parameters, and determining electricity consumption of each smart switch according to the average power and working hours of each smart switch, electricity consumption of one or more electronic devices controlled by respective smart switches can be thus counted automatically with one smart electricity meter and a plurality of smart switches. Thus, the number of required smart electricity meters may be reduced and the cost thereof may be saved, troublesome manual reading and statistical analysis may be eliminated, and smart home life may be more convenient.

As can be understood, both the general description above and the detailed description hereinafter are illustrative, rather than limitative to the present disclosure.

### BRIEF DESCRIPTION OF THE DRAWINGS

The accompanying drawings, which are incorporated in and constitute a part of this specification, illustrate the embodiments according to the present disclosure, and serve as explaining the principles of the present disclosure together with the description.

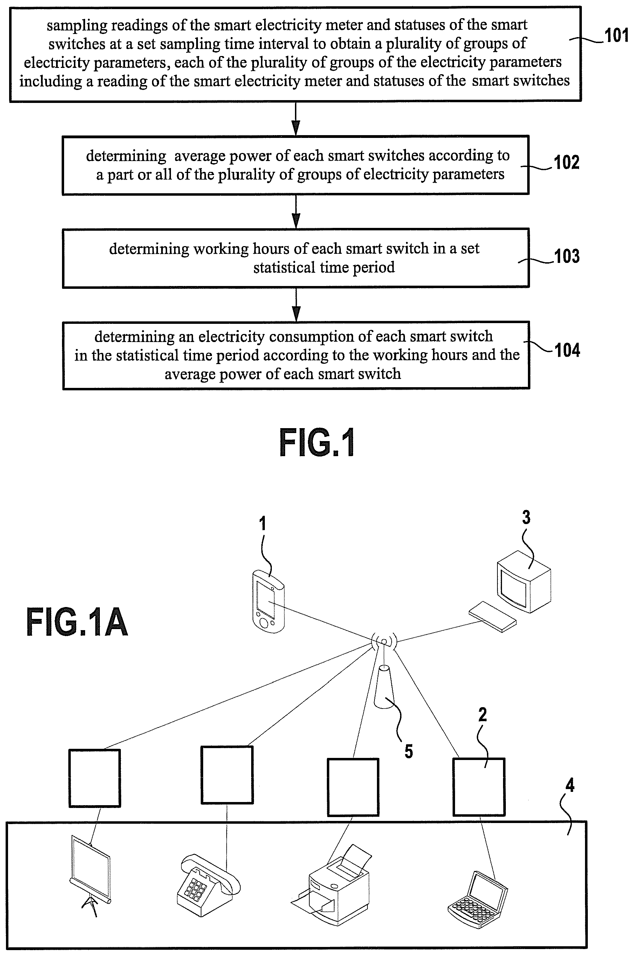

Fig. 1a illustrates a block diagram of application scenario shown by disclosed embodiments.
Fig. 1 illustrates a flow chart of a method for counting electricity consumption according to an exemplary embodiment.
Fig. 2 illustrates a flow chart of a method for counting electricity consumption according to an exemplary embodiment.
Fig. 3 illustrates a flow chart of a method for counting electricity consumption according to an exemplary embodiment.
Fig. 4 illustrates a block diagram of an apparatus for counting electricity consumption according to an exemplary embodiment.
Fig. 5 illustrates a block diagram of an apparatus for counting electricity consumption according to an exemplary embodiment.
Fig. 6 illustrates a block diagram of a system for counting electricity consumption according to an exemplary embodiment.
Fig. 7 illustrates a block diagram of an apparatus according to an exemplary embodiment.

### DETAILED DESCRIPTION

Herein, the exemplary embodiments will be described in detail, the examples of which are illustrated in the appended drawings. When the following description involves the appended drawings, the same reference number in the appended drawings illustrates the same or similar elements, unless otherwise. The implementation described in the following exemplary embodiments doesn't mean all the implementation consistent with the present disclosure. Rather, they are only examples of methods and apparatuses consistent with some aspects of the present disclosure detailed in the enclosed claims.

In order to better describe embodiments of the present disclosure, an application scenario of the present disclosure is firstly described in conjunction with Fig. 1a. The system includes: a smart electricity meter 1, a plurality of smart switches 2, a terminal 3 and a wireless access point 5. Each of the smart switches 2 is connected with one or more electronic devices 4, each of the smart switches 2 is connected with the smart electricity meter 1, and each of the smart switches 2 and the smart electricity meter 1 are wirelessly connected with the terminal 3 via the wireless access point 5.

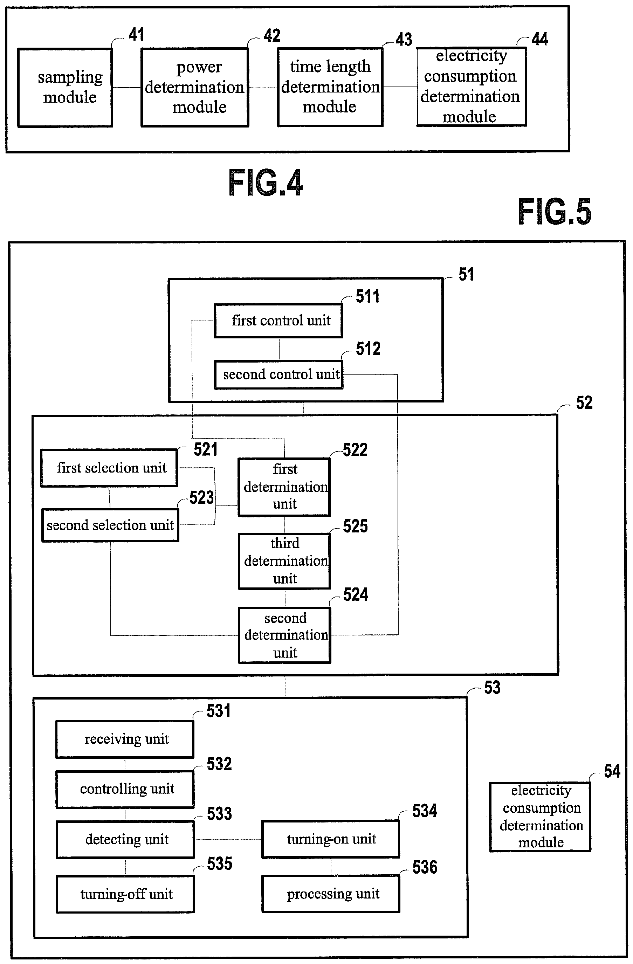

Herein, the terminal 3 is provided with apparatuses corresponding to Figs. 4, 5 and 7 in embodiments. All of the smart electricity meter 1, the smart switches 2 and the terminal 3 are provided with wireless communication modules, which may be connected with each other via a wireless network (e.g. WIFI), so as to enable the terminal 3 to perform interoperation among them such as data exchanges and control operations.

The electronic devices 4 may include all kinds of household appliances, such as TV sets, telephones, notebook computers, printers, fax machines, and so on.

Fig. 1 illustrates a flow chart of a method for counting electricity consumption according to an exemplary embodiment. As shown in Fig. 1, the method is applicable for counting electricity consumption for a plurality of electronic devices by using a smart electricity meter, wherein each of smart switches is respectively connected with one or more of the plurality of electronic devices and each of the smart switches is connected with the smart electricity meter. The method is applied in a terminal, and includes the following steps.

In step 101, readings of the smart electricity meter and statuses of the smart switches are sampled at a set sampling time interval to obtain a plurality of groups of electricity parameters, each of the plurality of groups of electricity parameters including a reading of the smart electricity meter and the statuses of the smart switches.

In step 102, an average power of each smart switch is determined according to a part or all of the plurality of groups of electricity parameters.

In step 103, working hours of each smart switch during a set statistical time period are determined.

Herein, the statuses of the smart switches include on-state and off-state, which corresponds to on-state and off-state of the electronic device connected thereto, respectively. In an embodiment, a smart switch may be provided to control an electronic device, such as a refrigerator or a water heater. Alternatively, a smart switch may be provided to control a plurality of electronic devices, such as cell phones and cameras relying on rechargeable batteries.

Each of the smart switches is in on-state within its working hours, and the working hours is less than or equal to a time period during which electricity consumption is counted. As can be easily understood, in this time period of counting electricity consumption, each smart switch or those smart switches to be counted may be turned on/off repeatedly, or may be kept in on-state. When a smart switch to be counted is turned on/off repeatedly, its working hours is less than the statistical time period; when a smart switch to be counted is kept in on-state, its working hours is equal to the statistical time period. In an embodiment, the statistical time period may be set manually, for example, to be one week or one month, or the like.

In step 104, electricity consumption of each smart switch during the statistical time period is determined according to the working hours and the average power of each smart switch.

Some advantageous effects of the present disclosure may include: by sampling a plurality of groups of electricity parameters at the set sampling time interval, determining the average power of each smart switch according to the electricity parameters, and then determining electricity consumption of each smart switch according to the average power and working hours of each smart switch, electricity consumption of one or more electronic devices controlled by respective smart switches can be thus counted automatically with only one smart electricity meter and a plurality of smart switches. Thus, the number of required smart electricity meters may be reduced and the cost thereof may be saved, troublesome manual reading and statistical analysis may be eliminated, and smart home life may be more convenient.

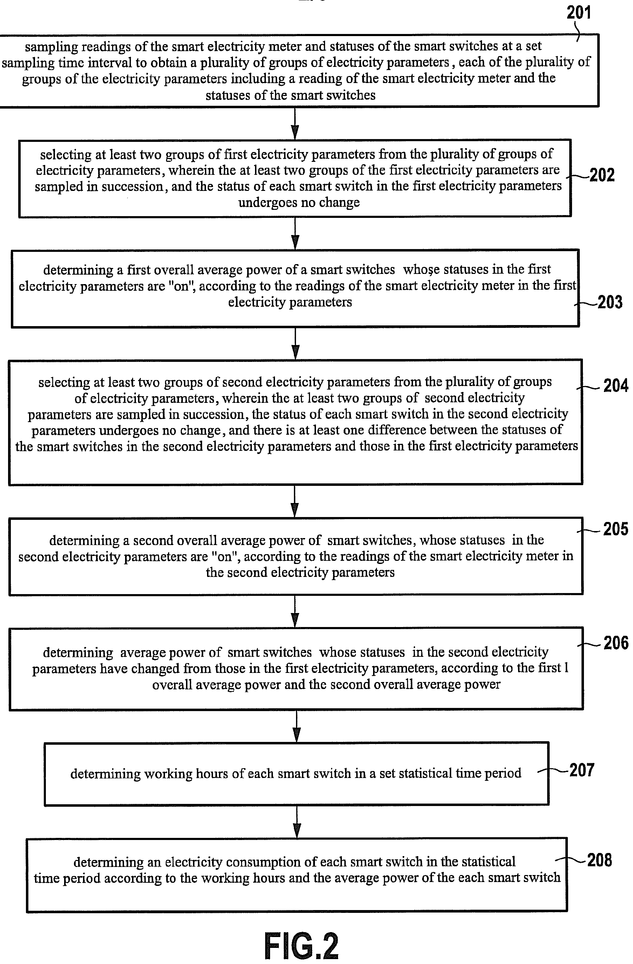

Fig. 2 illustrates a flow chart of a method for counting electricity consumption according to an exemplary embodiment. As shown in Fig. 2, the method is suitable to count electricity consumption for a plurality of electronic devices by using a smart electricity meter, in which each of smart switches is respectively connected with one or more of the plurality of electronic devices, and each of the smart switches is connected with the smart electricity meter. The method is applied in a terminal, and includes the following steps.

In step 201, readings of the smart electricity meter and statuses of the smart switches are sampled at a set sampling time interval to obtain a plurality of groups of electricity parameters, each of the plurality of groups of electricity parameters including a reading of the smart electricity meter and the statuses of the smart switches.

In some embodiments, each of the plurality of groups of electricity parameters may further include a sampling time interval. The sampling time interval may be set manually, for example, to 5 seconds, 30 seconds, 1 minute, or the like.

In some embodiments, an irregular sampling time interval may be employed. In this scenario, every sampling time interval may have to be recorded correspondingly. As can be easily understood, the shorter the sampling time interval is, the more the sampled data may be obtained during the same processing time period, whereby the result may be more accurate.

In some embodiments, every smart switch may be numbered. The reading of the smart electricity meter, the status of every smart switch and the sampling time interval in every group may be stored in the form of a list.

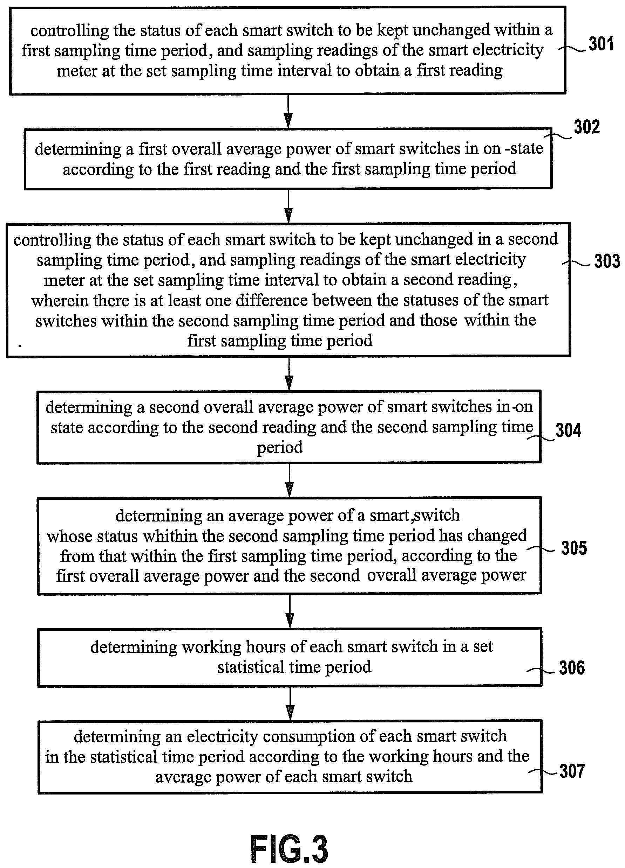

Due to a user's habits or reasons caused by the electronic device per se, there may be a situation in which statuses of not all of the electronic devices vary during working hours. Taking a refrigerator as an example, it will not be turned off in a relatively long time period (e.g. more than 3 years) once it is turned on. For this situation, smart switches controlling such kind of electronic devices may be classified into a special type. At this point in step 201, statuses of the smart switches other than such special type of smart switches and readings of the smart electricity meter have to be sampled at intervals to obtain a plurality of groups of electricity parameters. As can be easily understood, for N smart switches, when statuses of N-1 smart switches among them vary simultaneously, electricity consumption of the remaining smart switch (i.e. the special type of smart switches) can be determined. Alternatively, it may be achieved by the method in the embodiment corresponding to Fig. 3.

In step 202, at least two groups of first electricity parameters are selected from the plurality of groups of electricity parameters, wherein the at least two groups of first electricity parameters are sampled in succession, and the status of each smart switch in the first electricity parameters undergo no change.

In step 203, a first overall average power of smart switches, whose statuses in the first electricity parameters are "on", is determined according to the readings of the smart electricity meter in the first electricity parameters.
the step of determining a first overall average power of smart switches, whose statuses in the first electricity parameters are "on", according to the readings of the smart electricity meter in the first electricity parameters, includes but not limited to following steps:
A first, firstly sampled, reading value of the smart electricity meter and a second, lastly sampled, reading value of the smart electricity meter are classified into a group, being a group of first electricity parameters during a first time period;
at least two groups of the first reading value and the second reading value are determined;
at least two groups of differences between at least two groups of the first readings of the smart electricity meter sampled firstly and the second readings of the smart electricity meter sampled lastly are determined for the at least two groups; and
a first overall average power is determined according to the absolute value of the difference between the first reading and the second reading. Herein, the first overall average power is equal to a ratio of the difference between the first reading and the second reading to the length of the total sampling time for the at least two groups of first electricity parameters.

For purpose of ensuring an accurate result, sampled data of the at least two groups of first electricity parameters may be filtered before determining the absolute value of the difference between the first reading and the second reading. For example, data of one or more groups of electricity parameters with a larger deviation may be removed.

In step 204, at least two groups of second electricity parameters are selected from the plurality of groups of electricity parameters, wherein the at least two groups of the second electricity parameters are sampled in succession, the status of each smart switch in the second electricity parameters undergo no change, and there is at least one difference between the statuses of the smart switches in the second electricity parameters and those in the first electricity parameters.

As a preferred implementation, there is one difference between the statuses of the smart switches in the second electricity parameters and those in the first electricity parameters.

In step 205, a second overall average power of smart switches, whose statuses in the second electricity parameters are "on", is determined according to the readings of the smart electricity meter in the second electricity parameters.

The step of determining a second overall average power of smart switches, whose statuses in the second electricity parameters are "on", according to the readings of the smart electricity meter in the second electricity parameters, includes but not limited to following steps:
determining the absolute value of a difference between a third, firstly sampled, reading of the smart electricity meter and a fourth, lastly sampled, reading of the smart electricity meter during a second time period; and
determining a second overall average power according to the absolute value of the difference between the third reading and the fourth reading, wherein, the second overall average power is equal to a ratio of the absolute value of the difference between the third reading and the fourth reading to the length of the total sampling time for the at least two groups of second electricity parameters.

In step 206, average powers of smart switches, whose statuses in the second electricity parameters have changed from those in the first electricity parameters, is determined according to the first overall average power and the second overall average power.

When there are enough sampling data, a plurality of groups of electricity parameters may be proper and available to use in steps 202 and 204. That is, steps 202 and 204 may be processed repeatedly, so as to obtain a plurality of the first overall average powers and a plurality of the second overall average powers. In step 206, an average power of smart switches, whose statuses in the second electricity parameters have changed from those in the first electricity parameters, is determined according to the average value of the plurality of the first overall average powers and the average value of the plurality of the second overall average powers.

Steps 202-206 described above provide a method for determining the average power of any smart switch. In an embodiment, steps 202-206 may be processed repeatedly, so as to obtain the average power of every smart switch.

In step 207, working hours of each smart switch during a set statistical time period is determined.

In the embodiment, the step of determining the working hours of each smart switch during a set statistical time period may include the following steps of:
detecting if there is a turning-on instruction for turning on one or more smart switches;
when the turning-on instruction is detected, turning on the one or more smart switches, and controlling a timer, corresponding to the one or more smart switches turned on, to start timing, a timer being correspondingly provided to a smart switch;
detecting if there is a turning-off instruction, the turning-off instruction being used to turn off one or more smart switches;
when the turning-off instruction is detected, turning off the one or more smart switches, and controlling a timer, corresponding to the one or more smart switches turned off, to stop timing, a timer being correspondingly provided to a smart switch; and
determining if it comes to the end of the statistical time period, and if it does, reading a reading of the timer, and determining the working hours of the one or more smart switches according to the reading of the timer.

As can be easily understood, in an embodiment, each smart switch may be correspondingly provided with a timer, and a timer may be directly built into a smart switch, or may be provided in a terminal.

In this embodiment, the step of detecting the turning-on instruction and correspondingly starting the timer is performed prior to step 201, but the step of detecting the turning-off instruction and correspondingly stopping the timer is performed simultaneously with step 201.

In step 208, electricity consumption of each smart switch during the statistical time period is determined according to the working hours and the average power of each smart switch.

Herein, the electricity consumption of each smart switch is equal to the product of the average power and the working hours of each smart switch.

In an embodiment, when it is desired to know electricity consumption of a specified electronic device, it is only required to determine the working hours of the smart switch controlling that electronic device during the set statistical time period and the average power of the smart switch, which may be easily achieved.

In this embodiment, when it is the first time to determine the average power of each smart switch, steps 201-206 are processed repeatedly during the statistical time period. That is, the electricity consumption is counted simultaneously with the determination of the average power. As can be easily understood, once the average power of each smart switch is determined, when counting the electricity consumption based thereon, it is only required to determine the working hours of every smart switch during the statistical time period.

An example will be given hereinafter to illustrate steps 202-208.

Assuming there are a smart electricity meter A and three smart switches S1, S2 and S3. The three smart switches are connected with a TV set, a telephone and a printer, respectively. In order to count electricity consumption of the TV set, the telephone and the printer in one day, sampling starts from 08:00, respective timers respectively connected with the smart switches S1, S2 and S3 are controlled to simultaneously start timing, and the sampling time interval is 30 Second. The sampled electricity parameters include as follows (the unit for readings of the smart electricity meter is KWh). (1) Reading of A: 0.01; status of S1, S2, S3: on, on, on. (2) Reading of A: 0.02, status of S1, S2, S3: on, on, on. (3) Reading of A: 0. 03, S1, S2, S3: on, on, on; (4) Reading of A: 0.035, status of S1, S2, S3: off, on, on; (5) Reading of A: 0.04, status of S1, S2, S3: off, on, on; (6) Reading of A: 0.05, status of S1, S2, S3: on, on, on; (7) Reading of A: 0.055, status of S1, S2, S3: on, off, on; (8) Reading of A: 0.06, status of S1, S2, S3: on, off, on; (9) Reading of A: 0.065, status of S1, S2, S3: on, on, off; (10) Reading of A: 0.07, status of S1, S2, S3: on, on, off.

Taking the determination of the electricity consumption of the smart switch S3 controlling the printer in one day as an example, a detailed description will be given. In step 202, any combination of (1) and (2), (2) and (3), or (1), (2) and (3) may be selected. If the combination of (1) and (2) is selected, then in step 203, the first overall average power within 1 minute from 08:00-08:01 may be obtained as (0.02-0.01) /1min. In order to determine the average power of the smart switch S3, a combination of (9) and (10) should be selected in step 204, and the second overall average power may be obtained in step 205 as (0.07-0.065) /1 min. As should be noted here, required electricity parameters are directly selected in step 204, so as to determine the second overall average power. In step 206, the average power of the smart switch S3 may be obtained as 0.005/1min. Assuming that reading of the timer corresponding to the smart switch S3 in one day is 240 min, the electricity consumption of the smart switch S3 in one day is 240 min x 0.005/1min, that is, 1.2 KWh.

Some advantageous effects of the present disclosure may include: by sampling a plurality of groups of electricity parameters at a set sampling time interval, determining an average power of each smart switch according to the electricity parameters, and determining electricity consumption of each smart switch according to the average power and working hours of each smart switch, electricity consumption of one or more electronic devices controlled by respective smart switches can be thus counted automatically with one smart electricity meter and the plurality of smart switches. Thus, the number of required smart electricity meters may be reduced and the cost thereof may be saved, troublesome manual reading and statistical analysis may be eliminated, and smart home life may be more convenient. In addition, useful data is selected, from a plurality of groups of electricity parameters sampled, to determine the average powers of respective smart switches and the electricity consumptions of electronic devices controlled by respective smart switches. In such a manner, obtained result may be relatively accurate when the data quantity is enough.

Fig. 3 illustrates a flow chart of a method for counting electricity consumption according to an exemplary embodiment. As shown in Fig. 3, the method is suitable to count electricity consumption for a plurality of electronic devices by using a smart electricity meter, in which each of smart switches is respectively connected with one or more of the plurality of electronic devices, and each of the smart switches is connected with the smart electricity meter. The method is applied in a terminal, and includes the following steps.

In step 301, the status of each smart switch is controlled to be kept unchanged during a first sampling time period, and readings of the smart electricity meter are sampled at a set sampling time interval to obtain a first reading.

Herein, the length of the first sampling time period is greater than that of the sampling time interval mentioned above. That is, the electricity parameters may be sampled at least twice at the set sampling time interval, during the first sampling time period. As can be easily understood, in the embodiment, every group of electricity parameters may further include the sampling time interval.

In step 302, a first overall average power of smart switches that are in on-state is determined according to the first reading and the first sampling time period.

In an implementation, the first overall average power of the smart switches may be determined in the same manner as that in step 203, which will be omitted herein.

In step 303, the status of each smart switch is controlled to be kept unchanged during a second sampling time period, and readings of the smart electricity meter are sampled at a set sampling time interval to obtain a second reading, and there is at least one difference between the statuses of the smart switches within the second sampling time period and those within the first sampling time period.

The length of the second sampling period is greater than that of the sampling time interval mentioned above. That is, the electricity parameters may be sampled at least twice at the set sampling time interval within the second sampling period.

In an embodiment, the status of every smart switch may be controlled by on-off control instructions, which include a turning-on instruction and a turning-off instruction, in steps 301 and 303. Wherein, the turning-on instruction is used to turn on respective smart switches, while the turning-off instruction is used to turn off respective smart switches.

As in a preferred implementation, there is one difference between the statuses of the smart switches within the second sampling time period and those within the first sampling time period.

In step 304, a second overall average power of smart switches that are in on-state is determined according to the second reading and the second sampling time period.

As can be easily understood, steps 301 and 303 may be processed repeatedly, so as to obtain a plurality of sets of the first, second readings. Accordingly, a plurality of sets of the first and second overall average powers may be determined, so as to enhance accuracy of result.

In step 305, an average power of a smart switch, whose status within the first sampling time period has changed from that in the second sampling time period, is determined according to the first overall average power and the second overall average power.

Steps 301-305 described above provide a method for determining the average power of any smart switch. In an embodiment, steps 301-305 may be processed repeatedly, so as to obtain the average power of every smart switch.

Taking the embodiment corresponding to Fig. 2 as an example, the steps 301-305 will be illustrated in detail hereinafter.

In step 301, the statuses of the smart switches S1, S2 and S3 are controlled to be kept in on-state within time period of 08:00-08:01. Simultaneously, sampling is conducted twice at a sampling time interval of 30 seconds, and a first reading of the smart electricity meter A is read. Determination of the first overall average power in step 302 is the same as that in step 203. In step 303, the statuses of the smart switches S1, S2 and S3 are respectively controlled to be on, on and off, within time period of 08:02-08:04. Determinations of the second overall average power and the average power in steps 304 and 305 are the same as those in steps 205 and 206.

In step 306, working hours of each smart switch during a set statistical time period are determined.

In step 307, electricity consumption of each smart switch during the statistical time period is determined according to the working hours and the average power of each smart switch.

Steps 306 and 307 are the same as steps 207 and 208 described above, which are omitted herein.

As to be noted, in this embodiment, determination of the average power of each smart switch is finished before counting the electricity consumption.

Some advantageous effects of the present disclosure may include: by sampling a plurality of groups of electricity parameters at a set sampling time interval, determining the average power of each smart switch according to the electricity parameters, and determining electricity consumption of each smart switch according to the average power and working hours of each smart switch, electricity consumption of one or more electronic devices controlled by respective smart switches can be thus counted automatically with one smart electricity meter and a plurality of smart switches. Thus, the number of required smart electricity meters may be reduced and the cost thereof may be saved, troublesome manual reading and statistical analysis may be eliminated, and smart home life may be more convenient. In addition, useful data is selected, from a plurality of groups of electricity parameters being pre-sampled, to determine the average powers of respective smart switches and the electricity consumptions of electronic devices controlled by respective smart switches. In such a manner, the operation is simplified, and high efficiency may be achieved.

Fig. 4 illustrates a block diagram of an apparatus for counting electricity consumption according to an exemplary embodiment. Referring to Fig. 4, the apparatus includes a sampling module 41, a power determination module 42, a time length determination module 43 and an electricity consumption determination module 44.

The sampling module 41 is configured to sample readings of the smart electricity meter and statuses of the smart switches at a set sampling time interval to obtain a plurality of groups of electricity parameters, each of the plurality of groups of electricity parameters including a reading of the smart electricity meter and the statuses of the smart switches.

The power determination module 42 is configured to determine an average power of each smart switch according to a part or all of the plurality of groups of electricity parameters.

The time length determination module 43 is configured to determine working hours of each smart switch during a set statistical time period.

The electricity consumption determination module 44 is configured to determine electricity consumption of each smart switch during the statistical time period according to the working hours and the average power of each smart switch.

Some advantageous effects of the present disclosure may include: by acquiring a reading of the smart electricity meter and statuses of all of the smart switch to determine the average power of any smart switch and determining electricity consumption of any smart switch according to the average power and working hours of each smart switch, electricity consumption of one or more electronic devices controlled by respective smart switches can be thus counted automatically with one smart electricity meter and a plurality of smart switches. Thus, the number of required smart electricity meters may be reduced and the cost thereof may be saved, troublesome manual reading and statistical analysis may be eliminated, and smart home life may be more convenient.

Fig. 5 illustrates a block diagram of an apparatus for counting electricity consumption according to an exemplary embodiment. Referring to Fig. 5, the apparatus includes a sampling module 51, a power determination module 52, a time length determination module 53 and an electricity consumption determination module 54.

The sampling module 51 is configured to sample readings of the smart electricity meter and statuses of the smart switches at a set sampling time interval to obtain a plurality of groups of electricity parameters, each of the plurality of groups of electricity parameters including a reading of the smart electricity meter and statuses of the smart switches.

The power determination module 52 is configured to determine an average power of each smart switch according to a part or all of the plurality of groups of electricity parameters.

The time length determination module 53 is configured to determine working hours of each smart switch during a set statistical time period.

The electricity consumption determination module 54 is configured to determine electricity consumption of each smart switch during the statistical time period according to the working hours and the average power of each smart switch.

In an implementation, the power determination module 52 may include: a first selection unit 521, a first determination unit 522, a second selection unit 523, a second determination unit 524 and a third determination unit 525.

The first selection unit 521 is configured to select at least two groups of first electricity parameters from the plurality of groups of electricity parameters, wherein the at least two groups of first electricity parameters are sampled in succession, and the status of each smart switch in the first electricity parameters undergoes no change.

The first determination unit 522 is configured to determine a first overall average power of smart switches, whose statuses in the first electricity parameters are "on", according to readings of the smart electricity meter in the first electricity parameters.

The second selection unit 523 is configured to select at least two groups of second electricity parameters from the plurality of groups of electricity parameters, wherein the at least two groups of second electricity parameters are sampled in succession, the status of each smart switch in the second electricity parameters undergo no change, and there is at least one difference between the statuses of the smart switches in the second electricity parameters and those in the first electricity parameters.

The second determination unit 524 is configured to determine a second overall average power of smart switches, whose statuses in the second electricity parameters are "on", according to readings of the smart electricity meter in the second electricity parameters.

The third determination unit 525 is configured to determine an average power of a smart switch, whose status in the second electricity parameters has changed from that in the first electricity parameters , according to the first overall average power and the second overall average power.

In another implementation, the sampling module 51 may include: a first control unit 511 and a second control unit 512.

The first control unit 511 is configured to control the status of each smart switch to be kept unchanged during a first sampling time period, and to sample readings of the smart electricity meter at a set sampling time interval to obtain a first reading.

The second control unit 812 is configured to control the status of each smart switch to be kept unchanged during a second sampling time period, and to sample readings of the smart electricity meter at a set sampling time interval to obtain a second reading, and there is at least one difference between the statuses of the smart switches within the second sampling time period and those within the first sampling time period.

In such implementation, the first determination unit 522 is further configured to determine a first overall average power of smart switches in on-state according to the first reading and the first sampling time period.

The second determination unit 524 is further configured to determine a second overall average power of smart switches in on-state according to the second reading and the second sampling time period.

The third determination unit 525 is further configured to determine an average power of a smart switch, whose status within the second sampling time period has changed from that in the first sampling time period, according to the first overall average power and the second overall average power.

In the embodiment, the time length determination module 53 includes: a receiving unit 531, a controlling unit 532, a detecting unit 533, a turning-on unit 534, a turning-off unit 535 and a processing unit 536.

The receiving unit 531 is configured to receive on-off control instructions, which include a turning-on instruction and a turning-off instruction.

The controlling unit 532 is configured to control the status of each smart switch according to the on-off control instruction.

The detection unit 533 is configured to detect if there is a turning-on instruction, which is used to turn on respective smart switches.

The turning-on unit 534 is configured to turn on a smart switch when the turning-on instruction is detected, and control a timer, corresponding to the smart switch turned on, to start timing, a timer being correspondingly provided to a smart switch.

The detection unit 533 is further configured to detect if there is a turning-off instruction for turning off respective smart switches.

The turning-off unit 535 is configured to turn off a smart switch when the turning-off instruction is detected, and control a timer, corresponding to the smart switch turned off, to stop timing.

The processing unit 536 is configured to determine if it comes to the end of the statistical time period, and if it does, read a reading of the timer, and determine the working hours of each smart switch according to the reading of the timer.

Some advantageous effects of the present disclosure may include: by acquiring a reading of the smart electricity meter and statuses of all of the smart switch to determine the average power of any smart switch and determining electricity consumption of any smart switch according to the average power and working hours of each smart switch, electricity consumption of one or more electronic devices controlled by respective smart switches can be thus counted automatically with one smart electricity meter and a plurality of smart switches. Thus, the number of required smart electricity meters may be reduced and the cost thereof may be saved, troublesome manual reading and statistical analysis may be eliminated, and smart home life may be more convenient.

Specific manners for performing operation of every module in the apparatus according to embodiments mentioned above are detailed described in the embodiments of the method, and thus detailed description thereof will be omitted here.

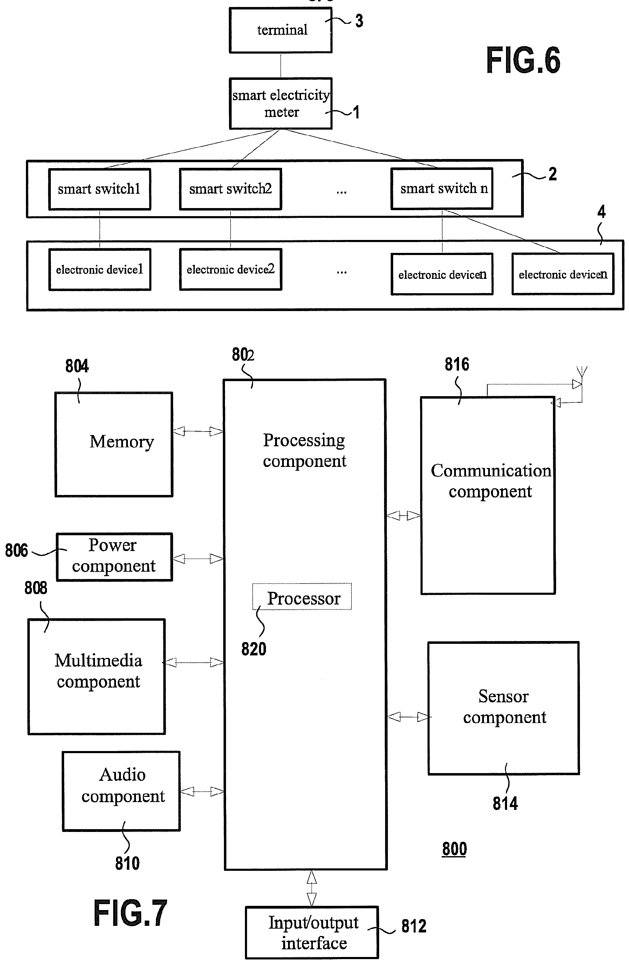

Fig. 6 illustrates a block diagram of a system for counting electricity consumption according to an exemplary embodiment. Referring to Fig. 6, the system includes: a smart electricity meter 1, a plurality of smart switches 2 and a terminal 3. Each of the smart switches 2 is connected with one or more electronic devices 4, each of the smart switches 2 is connected with the smart electricity meter 1, and each of the smart switches 2 and the smart electricity meter 1 are connected wirelessly with the terminal 3. The terminal 3 is provided therein with apparatuses in embodiments according to Figs. 4 and 5.

Herein, the smart electricity meter, each smart switch and the terminal are provided with wireless communication modules, which may be connected with each other via wireless network (e.g. WIFI). The electronic devices 4 may include all kinds of household appliances, such as TV sets, telephones, fax machines and notebook computers.

Some advantageous effects of the present disclosure may include: by acquiring a reading of the smart electricity meter and the statuses of all of the smart switches to determine the average power of any smart switch through a terminal, and determining electricity consumption of any smart switch according to the average power and working hours of each smart switch through the terminal, electricity consumption of one or more electronic devices controlled by respective smart switches can be thus counted automatically with one smart electricity meter and a plurality of smart switches. Thus, the number of required smart electricity meters may be reduced and the cost thereof may be saved, troublesome manual reading and statistical analysis may be eliminated, and smart home life may be more convenient.

Fig.7 is a block diagram of an apparatus 800 of counting electricity consumption according to an exemplary embodiment. For example, the apparatus 800 may be a mobile phone, a computer, a digital broadcast terminal, a message sending and receiving device, a game console, a tablet device, a medical equipment, a fitness equipment, personal digital assistants, etc...

Referring to Fig.7, the apparatus 800 may include one or more components: a processing component 802, a memory 804, a power component 806, a multimedia component 808, an audio component 810, an input/output (I/O) interface 812, a sensor component 814, and a communication component.

Th processing component 802 typically controls overall operations of the apparatus 800, such as the operations associated with display, telephone calls, data communications, camera operations, and recording operations. The processing component 802 may include one or more processors 820 to execute instructions to perform all or part of the steps in the above described methods. Moreover, the processing component 802 may include one or more modules which facilitate the interaction between the processing component 802 and other components. For instance, the processing component 802 may include a multimedia module to facilitate the interaction between the multimedia component 808 and the processing component 802.

The memory 804 is configured to store various types of data to support the operation of the apparatus 800. Examples of such data include instructions for any applications or methods operated on the apparatus 800, contact data, phonebook data, messages, pictures, video, etc. The memory 804 may be implemented using any type of volatile or non-volatile memory devices, or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic or optical disk.

The power component 806 provides power to various components of the apparatus 800. The power component 806 may include a power management system, one or more power sources, and any other components associated with the generation, management, and distribution of power in the apparatus 800.

The multimedia component 808 includes a screen providing an output interface between the apparatus 800 and the user. In some embodiments, the screen may include a liquid crystal display (LCD) and a touch panel (TP). If the screen includes the touch panel, the screen may be implemented as a touch screen to receive input signals from the user. The touch panel includes one or more touch sensors to sense touches, swipes, and gestures on the touch panel. The touch sensors may not only sense a boundary of a touch or swipe action, but also sense a period of time and a pressure associated with the touch or swipe action. In some embodiments, the multimedia component 808 includes a front camera and/or a rear camera. The front camera and the rear camera may receive an external multimedia datum while the apparatus 800 is in an operation mode, such as a photographing mode or a video mode. Each of the front camera and the rear camera may be a fixed optical lens system or have focus and optical zoom capability.

The audio component 810 is configured to output and/or input audio signals. For example, the audio component 810 includes a microphone ("MIC") configured to receive an external audio signal when the apparatus 800 is in an operation mode, such as a call mode, a recording mode, and a voice recognition mode. The received audio signal may be further stored in the memory 804 or transmitted via the communication component 816. In some embodiments, the audio component 810 further includes a speaker to output audio signals.

The I/O interface 812 provides an interface between the processing component 802 and peripheral interface modules, such as a keyboard, a click wheel, buttons, and the like. The buttons may include, but are not limited to, a home button, a volume button, a starting button, and a locking button.

The sensor component 814 includes one or more sensors to provide status assessments of various aspects of the apparatus 800. For instance, the sensor component 814 may detect an open/closed status of the apparatus 800, relative positioning of components, e.g., the display and the keypad, of the apparatus 800, a change in position of the apparatus 800 or a component of the apparatus 800, a presence or absence of user contact with the apparatus 800, an orientation or an acceleration/deceleration of the apparatus 800, and a change in temperature of the apparatus 800. The sensor component 814 may include a proximity sensor configured to detect the presence of nearby objects without any physical contact. The sensor component 814 may further include a light sensor, such as a CMOS or CCD image sensor, for use in imaging applications. In some embodiments, the sensor component 814 may further include an accelerometer sensor, a gyroscope sensor, a magnetic sensor, a pressure sensor, or a temperature sensor.

The communication component 816 is configured to facilitate communication, wired or wirelessly, between the apparatus 800 and other devices. The apparatus 800 can access a wireless network based on a communication standard, such as WiFi, 2G, or 3G, or a combination thereof. In one exemplary embodiment, the communication component 816 receives a broadcast signal or broadcast associated information from an external broadcast management system via a broadcast channel. In one exemplary embodiment, the communication component 816 further includes a near field communication (NFC) module to facilitate short-range communications. For example, the NFC module may be implemented based on a radio frequency identification (RFID) technology, an infrared data association (IrDA) technology, an ultra-wideband (UWB) technology, a Bluetooth (BT) technology, and other technologies.

In exemplary embodiments, the apparatus 800 may be implemented with one or more application specific integrated circuits (ASICs), digital signal processors (DSPs), digital signal processing devices (DSPDs), programmable logic devices (PLDs), field programmable gate arrays (FPGAs), controllers, micro-controllers, microprocessors, or other electronic components, for performing the above described methods.

In exemplary embodiments, there is also provided a non-transitory computer-readable storage medium including instructions, such as included in the memory 804, executable by the processor 820 in the apparatus 800, for performing the above-described methods. For example, the non-transitory computer-readable storage medium may be a ROM, a RAM, a CD-ROM, a magnetic tape, a floppy disc, an optical data storage device, and the like.

The person skilled in the art easily anticipates other solutions after consideration of the above description and implementation of the present disclosure. The present disclosure intends to cover any variation, usage or modification which follow a general principle of the present disclosure and include common knowledge or usual technical means in the art. The description and embodiments are exemplary and the scope and principle of the present disclosure are limited by the appending claims.

## Claims

1. A method for counting electricity consumption, which is applicable to count electricity consumption for a plurality of electronic devices (4) by using a smart electricity meter (1), a plurality of smart switches (2) being connected with the smart electricity meter (1), and each of the smart switches (2) being respectively connected with one or more of the plurality of electronic devices (4), **characterized in that**, the method comprises the steps of:
sampling (101, 201) readings of the smart electricity meter (1) and statuses of the smart switches (2) at a set sampling time interval to obtain a plurality of groups of electricity parameters, each of the plurality of groups of electricity parameters including a reading of the smart electricity meter (1) and the statuses of the smart switches (2);
determining (102) average power of each smart switch (2) according to a part or all of the plurality of groups of electricity parameters;
determining (103) working hours of each smart switch (2) in a set statistical time period; and
determining (104) an electricity consumption of each smart switch (2) in the statistical time period according to the working hours and the average power of each smart switch (2).

2. The method according to claim 1, the step (102) of determining average power of each smart switch (2) according to a part or all of the plurality of groups of electricity parameters, comprises the steps of:
selecting (202) at least two groups of first electricity parameters from the plurality of groups of electricity parameters, wherein the at least two groups of first electricity parameters are sampled in succession, and the status of each smart switch (2) in the first electricity parameters undergoes no change;
determining (203) a first overall average power of smart switches (2), whose statuses in the first electricity parameters are "on", according to the readings of the smart electricity meter (1) in the first electricity parameters;
selecting (204) at least two groups of second electricity parameters from the plurality of groups of electricity parameters, wherein the at least two groups of second electricity parameters are sampled in succession, the status of each smart switch (2) in the second electricity parameters undergoes no change, and there is at least one difference between the statuses of the smart switches (2) in the second electricity parameters and those in the first electricity parameters;
determining (205) a second overall average power of smart switches (2), whose statuses in the second electricity parameters are "on", according to the readings of the smart electricity meter (1) in the second electricity parameters; and
determining (206) average powers of smart switches (2), whose statuses in the second electricity parameters have changed from those in the first electricity parameters, according to the first overall average power and the second overall average power.

3. The method according to claim 1 or 2, the step (101, 201) of sampling readings of the smart electricity meter (1) and statuses of the smart switches (2) at a set sampling time interval to obtain a plurality of groups of electricity parameters, comprises the steps of:
controlling (301) the status of each smart switch (2) to be kept unchanged within a first sampling time period, and sampling readings of the smart electricity meter (1) at the set sampling time interval to obtain a first reading; and
controlling (303) the status of each smart switch (2) to be kept unchanged in a second sampling time period, and sampling readings of the smart electricity meter (1) at the set sampling time interval to obtain a second reading, wherein there is at least one difference between the statuses of the smart switches (2) within the second sampling time period and those within the first sampling time period.

4. The method according to claim 3, the step (102) of determining an average power of each smart switch (2) according to a part or all of the plurality of groups of electricity parameters, comprises the steps of:
determining (302) a first overall average power of smart switches (2) in on-state according to the first reading and the first sampling time period;
determining (304) a second overall average power of smart switches (2) in on-state according to the second reading and the second sampling time period; and
determining (305) an average power of a smart switch (2), whose status within the second sampling time period has changed from that within the first sampling time period, according to the first overall average power and the second overall average power.

5. The method according to any one of claims 1 to 5, the step (103) of determining working hours of each smart switch (2) in a set statistical time period, comprises the steps of:
detecting if there is a turning-on instruction for turning on one or more smart switches (2);
when the turning-on instruction is detected, turning on one or more smart switches (2), and controlling a timer, corresponding to the one or more smart switches (2) turned on, to start timing, a timer being correspondingly provided to a smart switch (2);
detecting if there is a turning-off instruction, the turning-off instruction being used to turn off one or more smart switches (2);
when the turning-off instruction is detected, turning off one or more smart switch (2), and controlling a timer, corresponding to the one or more smart switches (2) turned off, to stop timing; and
determining if it comes to the end of the statistical time period, and if it does, reading a reading of the timer, and determining the working hours of each smart switches (2) according to the reading of the timer.

6. An apparatus for counting electricity consumption, **characterized in that**, the apparatus comprises:
a sampling module (41, 51) configured to sample readings of a smart electricity meter (1) and statuses of smart switches (2), each of the smart switches (2) being connected with one or more electronic devices (4), at a set sampling time interval to obtain a plurality of groups of electricity parameters, each of the plurality of groups of electricity parameters including a reading of the smart electricity meter (1) and the statuses of the smart switches (2);
a power determination module (42, 52) configured to determine an average power of each smart switch (2) according to a part or all of the plurality of groups of electricity parameters;
a time length determination module (43, 53) configured to determine working hours of each smart switch (2) during a set statistical time period; and
an electricity consumption determination module (44) configured to determine electricity consumption of each smart switch (2) during the statistical time period according to the working hours and the average power of each smart switch (2).

7. The apparatus according to claim 6, the power determination module (52) comprises:
a first selection unit (521) configured to select at least two groups of first electricity parameters from the plurality of groups of electricity parameters, wherein the at least two groups of first electricity parameters are sampled in succession, and the status of each smart switch (2) in the first electricity parameters undergoes no change;
a first determination unit (522) configured to determine a first overall average power of smart switches (2) in on-state among the first electricity parameters according to the readings of the smart electricity meter (1) in the first electricity parameters;
a second selection unit (523), configured to select at least two groups of second electricity parameters from the plurality of groups of electricity parameters, wherein the at least two groups of second electricity parameters are sampled in succession, the status of each smart switch (2) in the second electricity parameters undergoes no change, and there is at least one difference between the statuses of the smart switches (2) in the second electricity parameters and those in the first electricity parameters;
a second determination unit (524) configured to determine a second overall average power of smart switches (2) in on-state among the second electricity parameters according to the readings of the smart electricity meter (1) in the second electricity parameters; and
a third determination unit (525), configured to determine an average power of a smart switch (2), whose status in the second electricity parameters has changed from that in the second electricity parameters, according to the first overall average power and the second overall average power.

8. The apparatus according to claim 6 or 7, the sampling module (51) comprises:
a first control unit (511) configured to control the status of each smart switch (2) to be kept unchanged in a first sampling time period, and sample readings of the smart electricity meter (1) at the set sampling time interval to obtain a first reading; and
a second control unit (512) configured to control the status of each smart switch (2) to be kept unchanged in a second sampling time period, and sample readings of the smart electricity meter (1) at the set sampling time interval to obtain a second reading, wherein there is at least one difference between the statuses of the smart switches (2) within the second sampling time period and those within the first sampling time period.

9. The apparatus according to claim 8, the first determination unit (511) is further configured to determine a first overall average power of smart switches (2) in on-state according to the first reading and the first sampling time period;
the second determination unit (512) is further configured to determine a second overall average power of smart switches (2) in on-state according to the second reading and the second sampling time period; and
the third determination unit (525) is further configured to determine an average power of a smart switch (2), whose status within the second sampling time period has changed from that within the first sampling time period, according to the first overall average power and the second overall average power.

10. The apparatus according to claim 6, the time length determination module (53) comprises:
a detection unit (533) configured to detect if there is a turning-on instruction, which is used to turn on respective smart switches (2);
a turning-on unit (534) configured to turn on a smart switch (2) when the turning-on instruction is detected, and control a timer, corresponding to the smart switch (2) turned on, to start timing, a timer being correspondingly provided to a smart switch (2);
the detection unit (533) further configured to detect if there is a turning-off instruction for turning off respective smart switches (2);
a turning-off unit (535) configured to turn off a smart switch (2) when the turning-off instruction is detected, and control the timer, corresponding to the smart switch (2) turned off, to stop timing; and
a processing unit (536) configured to determine if it comes to the end of the statistical time period, and if it does, read a reading of the timer, and determine the working hours of respective smart switches (2) according to the reading of the timer.

11. A system for counting electricity consumption, **characterized in that**, the system comprises:
a smart electricity meter (1), a plurality of smart switches (2) and a terminal (3), wherein each of the smart switches (2) is connected with one or more electronic devices (4), each of the smart switches (2) being connected with the smart electricity meter (1), each of the smart switches (2) and the smart electricity meter (1) are wirelessly connected with the terminal (3), and the terminal (3) is provided therein with the apparatus according to any one of claims 6-11.

12. A computer program including instructions for executing the steps of a method for counting electricity consumption according to any one of claims 1 to 5 when said program is executed by a computer.

13. A recording medium readable by a computer and having recorded thereon a computer program including instructions for executing the steps of a method for counting electricity consumption according to any one of claims 1 to 5.

## Patentansprüche

1. Verfahren zur Elektrizitätsverbrauchszählung, das dafür ausgelegt ist, den Elektrizitätsverbrauch für mehrere elektronische Vorrichtungen (4) unter Verwendung eines intelligenten Elektrizitätszählers (1) zu zählen, wobei mehrere intelligente Schalter (2) mit den intelligenten Elektrizitätszählern (1) verbunden sind, und jeder der intelligenten Schalter (2) jeweils mit einer oder mehreren der mehreren elektronischen Vorrichtungen (4) verbunden ist, **dadurch gekennzeichnet dass** das Verfahren die Schritte umfasst:
Abtasten (101, 201) von Messwerten des intelligenten Elektrizitätszählers (1) und des Status der intelligenten Schalter (2) in einem eingestellten Abtastzeitintervall, um mehrere Gruppen von Elektrizitätsparametern zu erhalten, wobei jede der mehreren Gruppen von Elektrizitätsparametern einen Messwert des intelligenten Elektrizitätszählers (1) und den Status der intelligenten Schalter (2) enthält,
Bestimmen (102) der durchschnittlichen Leistung jedes intelligenten Schalters (2) gemäß einem Teil oder allen der mehreren Gruppen von Elektrizitätsparametern,
Bestimmen (103) der Betriebsstunden jedes intelligenten Schalters (2) in einem eingestellten statistischen Zeitraum, und
Bestimmen (104) eines Elektrizitätsverbrauchs jedes intelligenten Schalters (2) in dem statistischen Zeitraum gemäß den Betriebsstunden und der durchschnittlichen Leistung jedes intelligenten Schalters (2).

2. Verfahren nach Anspruch 1, wobei der Schritt (102) des Bestimmens der durchschnittlichen Leistung jedes intelligenten Schalters (2) gemäß einem Teil oder allen der mehreren Gruppen von Elektrizitätsparametern den Schritte umfasst:
Auswählen (202) mindestens zweier Gruppen erster Elektrizitätsparameter aus den mehreren Gruppen von Elektrizitätsparametern, wobei die mindestens zwei Gruppen erster Elektrizitätsparameter nacheinander abgetastet werden, und der Status jedes intelligenten Schalters (2) in den ersten Elektrizitätsparametern keiner Änderung unterworfen wird,
Bestimmen (203) einer ersten durchschnittlichen Gesamtleistung von intelligenten Schaltern (2), deren Status in den ersten Elektrizitätsparametern "ein" ist, gemäß den Messwerten des intelligenten Elektrizitätszählers (1) in den ersten Elektrizitätsparametern,
Auswählen (204) mindestens zweier Gruppen zweiter Elektrizitätsparameter aus den mehreren Gruppen von Elektrizitätsparametern, wobei die mindestens zwei Gruppen zweiter Elektrizitätsparameter nacheinander abgetastet werden, der Status jedes intelligenten Schalters (2) in den zweiten Elektrizitätsparametern keiner Änderung unterworfen wird, und es mindestens einen Unterschied zwischen dem Status der intelligenten Schalter (2) in den zweiten Elektrizitätsparametern und dem in den ersten Elektrizitätsparametern gibt,
Bestimmen (205) einer zweiten durchschnittlichen Gesamtleistung von intelligenten Schaltern (2), deren Status in den zweiten Elektrizitätsparametern "ein" ist, gemäß den Messwerten des intelligenten Elektrizitätszählers (1) in den zweiten Elektrizitätsparametern, und
Bestimmen (206) der durchschnittlichen Leistungen von intelligenten Schaltern (2), deren Status in den zweiten Elektrizitätsparametern sich im Vergleich zu dem in den ersten Elektrizitätsparametern verändert hat, gemäß der ersten durchschnittlichen Gesamtleistung und der zweiten durchschnittlichen Gesamtleistung.

3. Verfahren nach Anspruch 1 oder 2, wobei der Schritt (101, 201) des Abtastens von Messwerten des intelligenten Elektrizitätszählers (1) und des Status der intelligenten Schalter (2) in einem eingestellten Abtastzeitintervall, um mehrere Gruppen von Elektrizitätsparametern zu erhalten, den Schritte umfasst:
Steuern (301) des Status jedes intelligenten Schalters (2) so, dass er innerhalb eines ersten Abtastzeitraums unverändert bleibt, und Abtasten von Messwerten des intelligenten Elektrizitätszählers (1) in dem eingestellten Abtastzeitintervall, um einen ersten Messwert zu erhalten, und
Steuern (303) des Status jedes intelligenten Schalters (2) so, dass er in einem zweiten Abtastzeitraum unverändert bleibt, und Abtasten von Messwerten des intelligenten Elektrizitätszählers (1) in dem eingestellten Abtastzeitintervall, um einen zweiten Messwert zu erhalten, wobei es mindestens einen Unterschied zwischen dem Status der intelligenten Schalter (2) innerhalb des zweiten Abtastzeitraums und dem innerhalb des ersten Abtastzeitraums gibt.

4. Verfahren nach Anspruch 3, wobei der Schritt (102) des Bestimmens einer durchschnittlichen Leistung jedes intelligenten Schalters (2) gemäß einem Teil oder allen der mehreren Gruppen von Elektrizitätsparametern die Schritte umfasst:
Bestimmen (302) einer ersten durchschnittlichen Gesamtleistung intelligenter Schalter (2) im Ein-Zustand gemäß dem ersten Messwert und dem ersten Abtastzeitraum,
Bestimmen (304) einer zweiten durchschnittlichen Gesamtleistung intelligenter Schalter (2) im Ein-Zustand gemäß dem zweiten Messwert und dem zweiten Abtastzeitraum, und
Bestimmen (305) einer durchschnittlichen Leistung eines intelligenten Schalters (2), deren Status innerhalb des zweiten Abtastzeitraums sich im Vergleich zu dem innerhalb des ersten Abtastzeitraums verändert hat, gemäß der ersten durchschnittlichen Gesamtleistung und der zweiten durchschnittlichen Gesamtleistung.

5. Verfahren nach einem der Ansprüche 1 bis 5, wobei der Schritt (103) des Bestimmens von Betriebsstunden jedes intelligenten Schalters (2) in einem eingestellten statistischen Zeitraum die Schritte umfasst:
Detektieren, ob es eine Einschaltanweisung zum Einschalten eines oder mehrerer intelligenter Schalter (2) gibt,
wenn die Einschaltanweisung detektiert wird, Einschalten eines oder mehrerer intelligenter Schalter (2), und Veranlassen eines Timers, entsprechend dem einen oder den mehreren eingeschalteten intelligenten Schaltern (2), eine Zeitnahme zu beginnen, wobei ein Timer entsprechend für einen intelligenten Schalter (2) bereitgestellt ist,
Detektieren, ob es eine Ausschaltanweisung gibt, wobei die Ausschaltanweisung dafür verwendet wird, einen oder mehrere intelligente Schalter (2) auszuschalten,
wenn die Ausschaltanweisung detektiert wird, Ausschalten eines oder mehrerer intelligenter Schalter (2), und Veranlassen eines Timers, entsprechend dem einen oder den mehreren ausgeschalteten intelligenten Schaltern (2), die Zeitnahme zu stoppen, und
Bestimmen, ob es zum Ende des statistischen Zeitraums kommt, und wenn ja, Lesen eines Messwertes des Timers, und Bestimmen der Betriebsstunden jedes intelligenten Schalters (2) gemäß dem Messwert des Timers.

6. Vorrichtung zur Elektrizitätsverbrauchszählung, **dadurch gekennzeichnet, dass** die Vorrichtung umfasst:
ein Abtastmodul (41, 51), das dafür konfiguriert ist, Messwerte eines intelligenten Elektrizitätszählers (1) und den Status intelligenter Schalter (2), wobei jeder der intelligenten Schalter (2) mit einer oder mehreren elektronischen Vorrichtungen (4) verbunden ist, in einem eingestellten Abtastzeitintervall abzutasten, um mehrere Gruppen von Elektrizitätsparametern zu erhalten, wobei jede der mehreren Gruppen von Elektrizitätsparametern einen Messwert des intelligenten Elektrizitätszählers (1) und den Status der intelligenten Schalter (2) enthält,
ein Leistungsbestimmungsmodul (42, 52), das dafür konfiguriert ist, eine durchschnittliche Leistung jedes intelligenten Schalters (2) gemäß einem Teil oder allen der mehreren Gruppen von Elektrizitätsparametern zu bestimmen,
ein Zeitlängenbestimmungsmodul (43, 53), das dafür konfiguriert ist, die Betriebsstunden jedes intelligenten Schalters (2) während eines eingestellten statistischen Zeitraums zu bestimmen, und
ein Elektrizitätsverbrauchsbestimmungsmodul (44), das dafür konfiguriert ist, den Elektrizitätsverbrauch jedes intelligenten Schalters (2) während des statistischen Zeitraums gemäß den Betriebsstunden und der durchschnittlichen Leistung jedes intelligenten Schalters (2) zu bestimmen.

7. Vorrichtung nach Anspruch 6, wobei das Leistungsbestimmungsmodul (52) umfasst:
eine erste Auswahleinheit (521), die dafür konfiguriert ist, mindestens zwei Gruppen erster Elektrizitätsparameter aus den mehreren Gruppen von Elektrizitätsparametern auszuwählen, wobei die mindestens zwei Gruppen erster Elektrizitätsparameter nacheinander abgetastet werden und der Status jedes intelligenten Schalters (2) in den ersten Elektrizitätsparametern keiner Änderung unterworfen wird,
eine erste Bestimmungseinheit (522), die dafür konfiguriert ist, eine erste durchschnittliche Gesamtleistung intelligenter Schalter (2) im Ein-Zustand unter den ersten Elektrizitätsparametern gemäß den Messwerten des intelligenten Elektrizitätszählers (1) in den ersten Elektrizitätsparametern zu bestimmen,
eine zweite Auswahleinheit (523), die dafür konfiguriert ist, mindestens zwei Gruppen zweiter Elektrizitätsparameter aus den mehreren Gruppen von Elektrizitätsparametern auszuwählen, wobei die mindestens zwei Gruppen zweiter Elektrizitätsparameter nacheinander abgetastet werden, der Status jedes intelligenten Schalters (2) in den zweiten Elektrizitätsparametern keiner Änderung unterworfen wird, und es mindestens einen Unterschied zwischen dem Status der intelligenten Schalter (2) in den zweiten Elektrizitätsparametern und dem in den ersten Elektrizitätsparametern gibt,
eine zweite Bestimmungseinheit (524), die dafür konfiguriert ist, eine zweite durchschnittliche Gesamtleistung intelligenter Schalter (2) im Ein-Zustand unter den zweiten Elektrizitätsparametern gemäß den Messwerten des intelligenten Elektrizitätszählers (1) in den zweiten Elektrizitätsparametern zu bestimmen, und
eine dritte Bestimmungseinheit (525), die dafür konfiguriert ist, eine durchschnittliche Leistung eines intelligenten Schalters (2), deren Status in den zweiten Elektrizitätsparametern sich im Vergleich zu dem in den zweiten Elektrizitätsparametern verändert, gemäß der ersten durchschnittlichen Gesamtleistung und der zweiten durchschnittlichen Gesamtleistung zu bestimmen.

8. Vorrichtung nach Anspruch 6 oder 7, wobei das Abtastmodul (51) umfasst:
eine erste Steuereinheit (511), die dafür konfiguriert ist, den Status jedes intelligenten Schalters (2) so zu steuern, dass er in einem ersten Abtastzeitraum unverändert bleibt, und Messwerte des intelligenten Elektrizitätszählers (1) in dem eingestellten Abtastzeitintervall abzutasten, um einen ersten Messwert zu erhalten, und
eine zweite Steuereinheit (512), die dafür konfiguriert ist, den Status jedes intelligenten Schalters (2) so zu steuern, dass er in einem zweiten Abtastzeitraum unverändert bleibt, und Messwerte des intelligenten Elektrizitätszählers (1) in dem eingestellten Abtastzeitintervall abzutasten, um einen zweiten Messwert zu erhalten, wobei es mindestens einen Unterschied zwischen dem Status der intelligenten Schalter (2) innerhalb des zweiten Abtastzeitraums und dem innerhalb des ersten Abtastzeitraums gibt.

9. Vorrichtung nach Anspruch 8, wobei die erste Bestimmungseinheit (511) ferner dafür konfiguriert ist, eine erste durchschnittliche Gesamtleistung intelligenter Schalter (2) im Ein-Zustand gemäß dem ersten Messwert und dem ersten Abtastzeitraum zu bestimmen,
die zweite Bestimmungseinheit (512) ferner dafür konfiguriert ist, eine zweite durchschnittliche Gesamtleistung intelligenter Schalter (2) im Ein-Zustand gemäß dem zweiten Messwert und dem zweiten Abtastzeitraum zu bestimmen, und
die dritte Bestimmungseinheit (525) ferner dafür konfiguriert ist, eine durchschnittliche Leistung eines intelligenten Schalters (2), dessen Status innerhalb des zweiten Abtastzeitraums sich im Vergleich zu dem innerhalb des ersten Abtastzeitraums verändert hat, gemäß der ersten durchschnittlichen Gesamtleistung und der zweiten durchschnittlichen Gesamtleistung zu bestimmen.

10. Vorrichtung nach Anspruch 6, wobei das Zeitlängenbestimmungsmodul (53) umfasst:
eine Detektionseinheit (533), die dafür konfiguriert ist zu detektieren, ob es eine Einschaltanweisung gibt, die dafür verwendet wird, jeweilige intelligente Schalter (2) einzuschalten,
eine Einschalteinheit (534), die dafür konfiguriert ist, einen intelligenten Schalter (2) einzuschalten, wenn die Einschaltanweisung detektiert wird, und einen Timer, entsprechend dem eingeschalteten intelligenten Schalter (2), zu veranlassen, eine Zeitnahme zu beginnen, wobei ein Timer entsprechend für einen intelligenten Schalter (2) bereitgestellt ist,
wobei die Detektionseinheit (533) ferner dafür konfiguriert ist zu detektieren, ob es eine Ausschaltanweisung zum Ausschalten jeweiliger intelligenter Schalter (2) gibt,
eine Ausschalteinheit (535), die dafür konfiguriert ist, einen intelligenten Schalter (2) auszuschalten, wenn die Ausschaltanweisung detektiert wird, und den Timer, entsprechend dem ausgeschalteten intelligenten Schalter (2), zu veranlassen, die Zeitnahme zu stoppen, und
eine Verarbeitungseinheit (536), die dafür konfiguriert ist zu bestimmen, ob es zum Ende des statistischen Zeitraums kommt, und wenn ja, einen Messwert des Timers zu lesen, und die Betriebsstunden jeweiliger intelligenter Schalter (2) gemäß dem Messwert des Timers zu bestimmen.

11. System zur Elektrizitätsverbrauchszählung, **dadurch gekennzeichnet, dass** das System umfasst:
einen intelligenten Elektrizitätszähler (1), mehrere intelligente Schalter (2) und einen Anschluss (3), wobei jeder der intelligenten Schalter (2) mit einer oder mehreren elektronischen Vorrichtungen (4) verbunden ist, wobei jeder der intelligenten Schalter (2) mit dem intelligenten Elektrizitätszähler (1) verbunden ist, wobei jeder der intelligenten Schalter (2) und der intelligente Elektrizitätszähler (1) drahtlos mit dem Anschluss (3) verbunden sind, und in dem Anschluss (3) mit der Vorrichtung nach einem der Ansprüche 6-11 ausgestattet ist.

12. Computerprogramm, das Anweisungen zum Ausführen der Schritte eines Verfahrens zur Elektrizitätsverbrauchszählung nach einem der Ansprüche 1 bis 5 enthält, wenn das Programm durch einen Computer ausgeführt wird.

13. Aufzeichnungsmedium, das durch einen Computer gelesen werden kann, und auf dem ein Computerprogramm aufgezeichnet ist, das Anweisungen zum Ausführen der Schritte eines Verfahrens zur Elektrizitätsverbrauchszählung nach einem der Ansprüche 1 bis 5 enthält.

## Revendications

1. Procédé pour compter une consommation d'électricité, qui est applicable pour compter une consommation d'électricité pour une pluralité de dispositifs électroniques (4) en utilisant un compteur électrique intelligent (1), une pluralité de commutateurs intelligents (2) étant connectés au compteur électrique intelligent (1), et chacun des commutateurs intelligents (2) étant respectivement connecté à un ou plusieurs de la pluralité de dispositifs électroniques (4), **caractérisé en ce que** le procédé comprend les étapes :
d'échantillonnage (101, 201) des lectures du compteur électrique intelligent (1) et des états des commutateurs intelligents (2) à un intervalle de temps d'échantillonnage fixé pour obtenir une pluralité de groupes de paramètres électriques, chacun de la pluralité de groupes de paramètres électriques comprenant une lecture du compteur électrique intelligent (1) et les états des commutateurs intelligents (2) ;
de détermination (102) de la puissance moyenne de chaque commutateur intelligent (2) conformément à une partie ou à la totalité de la pluralité de groupes de paramètres électriques ;
de détermination (103) des heures de fonctionnement de chaque commutateur intelligent (2) pendant une période de temps statistique fixée ; et
de détermination (104) d'une consommation d'électricité de chaque commutateur intelligent (2) pendant la période de temps statistique conformément aux heures de fonctionnement et à la puissance moyenne de chaque commutateur intelligent (2).

2. Procédé selon la revendication 1, dans lequel l'étape (102) de détermination de la puissance moyenne de chaque commutateur intelligent (2) conformément à une partie ou à la totalité de la pluralité de groupes de paramètres électriques comprend les étapes :
de sélection (202) d'au moins deux groupes de premiers paramètres électriques parmi la pluralité de groupes de paramètres électriques, dans lequel lesdits au moins deux groupes de premiers paramètres électriques sont échantillonnés successivement, et l'état de chaque commutateur intelligent (2) dans les premiers paramètres électriques ne subit aucun changement ;
de détermination (203) d'une première puissance moyenne globale des commutateurs intelligents (2), dont les états dans les premiers paramètres électriques sont « actifs », conformément aux lectures du compteur électrique intelligent (1) dans les premiers paramètres électriques ;
de sélection (204) d'au moins deux groupes de deuxièmes paramètres électriques parmi la pluralité de groupes de paramètres électriques, dans lequel lesdits au moins deux groupes de deuxièmes paramètres électriques sont échantillonnés successivement, l'état de chaque commutateur intelligent (2) dans les deuxièmes paramètres électriques ne subit aucun changement, et il existe au moins une différence entre les états des commutateurs intelligents (2) dans les deuxièmes paramètres électriques et ceux dans les premiers paramètres électriques ;
de détermination (205) d'une deuxième puissance moyenne globale des commutateurs intelligents (2), dont les états dans les deuxièmes paramètres électriques sont « actifs », conformément aux lectures du compteur électrique intelligent (1) dans les deuxièmes paramètres électriques ; et
de détermination (206) des puissances moyennes des commutateurs intelligents (2), dont les états dans les deuxièmes paramètres électriques ont changé par rapport à ceux dans les premiers paramètres électriques, conformément à la première puissance moyenne globale et à la deuxième puissance moyenne globale.

3. Procédé selon la revendication 1 ou 2, dans lequel l'étape (101, 201) d'échantillonnage des lectures du compteur électrique intelligent (1) et des états des commutateurs intelligents (2) à un intervalle de temps d'échantillonnage fixé pour obtenir une pluralité de groupes de paramètres électriques comprend les étapes :
de commande (301) de l'état de chaque commutateur intelligent (2) pour qu'il soit maintenu inchangé pendant une première période de temps d'échantillonnage, et d'échantillonnage des lectures du compteur électrique intelligent (1) à l'intervalle de temps d'échantillonnage fixé pour obtenir une première lecture ; et
de commande (303) de l'état de chaque commutateur intelligent (2) pour qu'il soit maintenu inchangé pendant une deuxième période de temps d'échantillonnage, et d'échantillonnage des lectures du compteur électrique intelligent (1) à l'intervalle de temps d'échantillonnage fixé pour obtenir une deuxième lecture, dans lequel il existe au moins une différence entre les états des commutateurs intelligents (2) pendant la deuxième période de temps d'échantillonnage et ceux pendant la première période de temps d'échantillonnage.

4. Procédé selon la revendication 3, dans lequel l'étape (102) de détermination d'une puissance moyenne de chaque commutateur intelligent (2) conformément à une partie ou à la totalité de la pluralité de groupes de paramètres électriques comprend les étapes :
de détermination (302) d'une première puissance moyenne globale des commutateurs intelligents (2) dans l'état actif conformément à la première lecture et à la première période de temps d'échantillonnage ;
de détermination (304) d'une deuxième puissance moyenne globale des commutateurs intelligents (2) dans l'état actif conformément à la deuxième lecture et à la deuxième période de temps d'échantillonnage ; et
de détermination (305) d'une puissance moyenne d'un commutateur intelligent (2), dont l'état pendant la deuxième période de temps d'échantillonnage a changé par rapport à celui pendant la première période de temps d'échantillonnage, conformément à la première puissance moyenne globale et à la deuxième puissance moyenne globale.

5. Procédé selon l'une quelconque des revendications 1 à 5, dans lequel l'étape (103) de détermination des heures de fonctionnement de chaque commutateur intelligent (2) pendant une période de temps statistique fixée comprend les étapes :
de détection s'il existe une instruction d'activation pour activer un ou plusieurs commutateurs intelligents (2) ;
lorsque l'instruction d'activation est détectée, d'activation d'un ou de plusieurs commutateurs intelligents (2), et de commande d'un registre d'horloge, correspondant aux dits un ou plusieurs commutateurs intelligents (2) activés, pour débuter un comptage de temps, un registre d'horloge étant prévu en correspondance avec un commutateur intelligent (2) ;
de détection s'il existe une instruction de désactivation, l'instruction de désactivation étant utilisée pour désactiver un ou plusieurs commutateurs intelligents (2) ;
lorsque l'instruction de désactivation est détectée, de désactivation d'un ou de plusieurs commutateurs intelligents (2), et de commande d'un registre d'horloge, correspondant aux dits un ou plusieurs commutateurs intelligents (2) désactivés, pour arrêter le comptage de temps ; et
de détermination si la fin de la période de temps statistique est atteinte, et si c'est le cas, de lecture d'une lecture du registre d'horloge, et de détermination des heures de fonctionnement de chaque commutateur intelligent (2) conformément à la lecture du registre d'horloge.

6. Appareil pour compter une consommation d'électricité, **caractérisé en ce que** l'appareil comprend :
un module d'échantillonnage (41, 51) configuré pour échantillonner les lectures d'un compteur électrique intelligent (1) et les états de commutateurs intelligents (2), chacun des commutateurs intelligents (2) étant connecté à un ou plusieurs dispositifs électroniques (4), à un intervalle de temps d'échantillonnage fixé pour obtenir une pluralité de groupes de paramètres électriques, chacun de la pluralité de groupes de paramètres électriques comprenant une lecture du compteur électrique intelligent (1) et les états des commutateurs intelligents (2) ;
un module de détermination de puissance (42, 52) configuré pour déterminer une puissance moyenne de chaque commutateur intelligent (2) conformément à une partie ou à la totalité de la pluralité de groupes de paramètres électriques ;
un module de détermination de durée (43, 53) configuré pour déterminer les heures de fonctionnement de chaque commutateur intelligent (2) pendant une période de temps statistique fixée ; et
un module de détermination de consommation d'électricité (44) configuré pour déterminer la consommation d'électricité de chaque commutateur intelligent (2) pendant la période de temps statistique conformément aux heures de fonctionnement et à la puissance moyenne de chaque commutateur intelligent (2).

7. Appareil selon la revendication 6, dans lequel le module de détermination de puissance (52) comprend :
une première unité de sélection (521) configurée pour sélectionner au moins deux groupes de premiers paramètres électriques parmi la pluralité de groupes de paramètres électriques, dans lequel lesdits au moins deux groupes de premiers paramètres électriques sont échantillonnés successivement, et l'état de chaque commutateur intelligent (2) dans les premiers paramètres électriques ne subit aucun changement ;
une première unité de détermination (522) configurée pour déterminer une première puissance moyenne globale des commutateurs intelligents (2) dans l'état actif parmi les premiers paramètres électriques conformément aux lectures du compteur électrique intelligent (1) dans les premiers paramètres électriques ;
une deuxième unité de sélection (523), configurée pour sélectionner au moins deux groupes de deuxièmes paramètres électriques parmi la pluralité de groupes de paramètres électriques, dans lequel lesdits au moins deux groupes de deuxièmes paramètres électriques sont échantillonnés successivement, l'état de chaque commutateur intelligent (2) dans les deuxièmes paramètres électriques ne subit aucun changement, et il existe au moins une différence entre les états des commutateurs intelligents (2) dans les deuxièmes paramètres électriques et ceux dans les premiers paramètres électriques ;
une deuxième unité de détermination (524) configurée pour déterminer une deuxième puissance moyenne globale des commutateurs intelligents (2) dans l'état actif parmi les deuxièmes paramètres électriques conformément aux lectures du compteur électrique intelligent (1) dans les deuxièmes paramètres électriques ; et
une troisième unité de détermination (525), configurée pour déterminer une puissance moyenne d'un commutateur intelligent (2), dont l'état dans les deuxièmes paramètres électriques a changé par rapport à celui dans les deuxièmes paramètres électriques, conformément à la première puissance moyenne globale et à la deuxième puissance moyenne globale.

8. Appareil selon la revendication 6 ou 7, dans lequel le module d'échantillonnage (51) comprend :
une première unité de commande (511) configurée pour commander l'état de chaque commutateur intelligent (2) pour qu'il soit maintenu inchangé pendant une première période de temps d'échantillonnage, et échantillonner les lectures du compteur électrique intelligent (1) à l'intervalle de temps d'échantillonnage fixé pour obtenir une première lecture ; et
une deuxième unité de commande (512) configurée pour commander l'état de chaque commutateur intelligent (2) pour qu'il soit maintenu inchangé pendant une deuxième période de temps d'échantillonnage, et échantillonner les lectures du compteur électrique intelligent (1) à l'intervalle de temps d'échantillonnage fixé pour obtenir une deuxième lecture, dans lequel il existe au moins une différence entre les états des commutateurs intelligents (2) pendant la deuxième période de temps d'échantillonnage et ceux pendant la première période de temps d'échantillonnage.

9. Appareil selon la revendication 8, dans lequel la première unité de détermination (511) est en outre configurée pour déterminer une première puissance moyenne globale des commutateurs intelligents (2) dans l'état actif conformément à la première lecture et à la première période de temps d'échantillonnage ;
la deuxième unité de détermination (512) est en outre configurée pour déterminer une deuxième puissance moyenne globale des commutateurs intelligents (2) dans l'état actif conformément à la deuxième lecture et à la deuxième période de temps d'échantillonnage ; et
la troisième unité de détermination (525) est en outre configurée pour déterminer une puissance moyenne d'un commutateur intelligent (2), dont l'état pendant la deuxième période de temps d'échantillonnage a changé par rapport à celui pendant la première période de temps d'échantillonnage, conformément à la première puissance moyenne globale et à la deuxième puissance moyenne globale.

10. Appareil selon la revendication 6, dans lequel le module de détermination de durée (53) comprend :
une unité de détection (533) configurée pour détecter s'il existe une instruction d'activation, qui est utilisée pour activer les commutateurs intelligents (2) respectifs ;
une unité d'activation (534) configurée pour activer un commutateur intelligent (2) lorsque l'instruction d'activation est détectée, et commander un registre d'horloge, correspondant au commutateur intelligent (2) activé, pour débuter un comptage de temps, un registre d'horloge étant prévu en correspondance avec un commutateur intelligent (2) ;
l'unité de détection (533) étant en outre configurée pour détecter s'il existe une instruction de désactivation pour désactiver les commutateurs intelligents (2) respectifs ;
une unité de désactivation (535) configurée pour désactiver un commutateur intelligent (2) lorsque l'instruction de désactivation est détectée, et commander le registre d'horloge, correspondant au commutateur intelligent (2) désactivé, pour arrêter le comptage de temps ; et
une unité de traitement (536) configurée pour déterminer si la fin de la période de temps statistique est atteinte, et si c'est le cas, pour lire une lecture du registre d'horloge, et pour déterminer les heures de fonctionnement des commutateurs intelligents (2) respectifs conformément à la lecture du registre d'horloge.

11. Système pour compter une consommation d'électricité, **caractérisé en ce que** le système comprend :
un compteur électrique intelligent (1), une pluralité de commutateurs intelligents (2) et un terminal (3), dans lequel chacun des commutateurs intelligents (2) est connecté à un ou plusieurs dispositifs électroniques (4), chacun des commutateurs intelligents (2) étant connecté au compteur électrique intelligent (1), chacun des commutateurs intelligents (2) et le compteur électrique intelligent (1) sont connectés par une liaison sans fil au terminal (3), et le terminal (3) est pourvu dans celui-ci de l'appareil selon l'une quelconque des revendications 6 à 11.

12. Programme d'ordinateur comprenant des instructions pour exécuter les étapes d'un procédé pour compter une consommation d'électricité selon l'une quelconque des revendications 1 à 5 lorsque ledit programme est exécuté par un ordinateur.

13. Support d'enregistrement pouvant être lu par un ordinateur et sur lequel est enregistré un programme d'ordinateur comprenant des instructions pour exécuter les étapes d'un procédé pour compter une consommation d'électricité selon l'une quelconque des revendications 1 à 5.
